# FASCICULE DE BREVET EUROPEEN

(11) **EP 3 434 426 B1**
(45) Date de publication et mention de la délivrance du brevet: **26.02.2020**
(21) Numéro de dépôt: 18181590.3
(22) Date de dépôt: 04.07.2018
(51) Int. Cl.: B25J 13/08, B25J 19/02, B25J 19/06

(54) **ROBOT MUNI DE MOYENS DE DÉTECTION CAPACITIFS ET D'ORGANE(S) RÉFÉRENCÉ(S) À UN POTENTIEL DE GARDE**
ROBOTER, DER MIT KAPAZITIVEN DETEKTIONSMITTELN UND AUF EIN SCHUTZPOTENZIAL EINGESTELLTEN ORGANEN AUSGESTATTET IST
ROBOT WITH CAPACITIVE DETECTION MEANS AND REFERENCED ORGAN(S) WITH A GUARD POTENTIAL

(30) Priorité: 26.07.2017 WO PCT/FR2017/052087
(43) Date de publication de la demande: 30.01.2019
(73) Titulaire: Fogale Nanotech, 30900 Nimes (FR)
(72) Inventeur: ROZIERE, Didier, 30900 Nîmes (FR); OSSART, Frédéric, 30980 Langlade (FR)
(74) Mandataire: IPAZ

(56) Documents cités:
- WO-A1-2014/101943
- US-A- 5 166 679
- US-A- 5 363 051

## Description

### Domaine technique

La présente invention concerne un robot équipé de moyens de détection capacitifs et dont au moins un organe électrique est électriquement référencé à un potentiel de garde différent d'un potentiel de masse générale.

Le domaine de l'invention est, de manière non limitative, celui du domaine de la robotique, en particulier le domaine de la robotique industrielle ou des robots de service, par exemple médical ou domestique, ou encore des robots collaboratifs, également appelés « cobots ».

### Etat de la technique

Les robots industriels ou domestiques, en particulier les cobots, comprennent généralement un corps sur lequel est fixée une tête fonctionnelle, se présentant sous la forme d'un outil ou d'un porte-outil, leur permettant d'accomplir une ou plusieurs tâches dans un environnement.

Ces robots interviennent dans de plus en plus d'applications, soit de manière complétement autonome, soit en assistance à une personne ou à un opérateur. Ils sont généralement équipés de capteurs leur permettant de détecter les objets et personnes se trouvant dans leur environnement, en vue d'assurer la sécurité du robot, mais aussi des objets et personnes environnants. Ces capteurs peuvent être réalisés par des électrodes de détection capacitives, voir par exemple les documents US5166679 et US5363051.

Cependant, les inventeurs ont constaté que dans certaines situations, les électrodes capacitives équipant la paroi externe du robot, détectent les organes électriques se trouvant dans le robot lui-même, en particulier lorsque le robot est un bras robotisé comprenant plusieurs segments articulés. Une telle détection, appelée « auto-détection » dans la suite, limite l'amplitude de fonctionnement du robot. En effet, cette auto-détection peut masquer la présence d'un objet ou d'une personne approchant le robot et empêcher sa détection, ce qui est inacceptable du point de vue de la sécurité. Il s'ensuit que dans certains cas, le robot peut se mettre dans un mode de fonctionnement dégradé, ou se bloquer inutilement par soucis de sécurité.

Un but de la présente invention est de pallier cet inconvénient.

Un autre but de la présente invention est de proposer un robot équipé d'une fonctionnalité de détection plus efficace.

Un autre but de la présente invention est de proposer un robot équipé d'une fonctionnalité de détection évitant les auto-détections.

Un autre but de la présente invention est de proposer un robot équipé d'une fonctionnalité de détection ne limitant pas l'amplitude de fonctionnement du robot et ne pénalisant le fonctionnement du robot.

### Exposé de l'invention

Au moins un de ces buts est atteint avec un robot comprenant une ou plusieurs sous-partie(s), dont au moins une, dite sous-partie appareillée, comportant au moins un organe électrique disposé dans ladite sous-partie, ledit robot comprenant en outre :
- pour au moins une sous-partie, dite équipée, au moins une électrode de détection capacitive, dite de mesure, disposée sur, ou dans, une paroi externe de ladite sous-partie, en particulier électriquement isolée de ladite paroi externe lorsque ladite paroi externe est conductrice d'électricité,
- au moins un moyen de polarisation électrique pour polariser ladite au moins une électrode de mesure à un premier potentiel électrique alternatif, différent d'un potentiel de masse générale, à une fréquence, dite de travail, et
- au moins une électronique, dite de détection, pour mesurer un signal relatif à une capacité de couplage, dite capacité électrode-objet, entre l'au moins une électrode de mesure et un objet environnant ;
**caractérisé en ce que,** pour au moins une sous-partie appareillée dont la paroi externe est, au moins en partie, non-conductrice d'électricité, ledit au moins un moyen de polarisation est en outre agencé pour garder électriquement au moins un organe électrique de ladite sous-partie appareillée, à un potentiel électrique alternatif (V_{G}), dit de garde, identique ou sensiblement identique audit premier potentiel à ladite fréquence de travail.

Lorsqu'un organe électrique, référencé à un potentiel électrique, par exemple un potentiel de masse générale (MG), différent du potentiel de garde, se trouve dans une sous-partie dont la paroi externe n'est pas électriquement conductrice, cet organe peut être détecté par les électrodes de mesure équipant le robot et provoquer une auto-détection. L'invention propose de remédier à cet inconvénient en gardant électriquement un tel organe électrique au potentiel de garde (V_{G}) de sorte qu'il devient électriquement invisible par les électrodes de détection capacitives équipant ledit robot. Par conséquent, un tel organe, gardé au potentiel de garde, ne sera pas détecté par les électrodes de mesure comme étant un objet environnant. Le robot selon l'invention est donc équipé d'une fonctionnalité de détection plus efficace, qui ne limite pas l'amplitude de fonctionnement du robot.

Garder électriquement un organe électrique signifie faire en sorte que pour les éléments environnants il apparaisse comme étant globalement polarisé au potentiel de garde. Comme cela sera expliqué plus loin, cela peut être réalisé par exemple en le polarisant ou en l'incluant dans une enceinte polarisée au potentiel de garde.

Le fait de polariser des éléments au potentiel de garde permet d'éviter l'apparition de capacités de fuite ou parasites entre les électrodes de détection capacitives et ces éléments à la garde. Ainsi la présence de ces éléments de garde permet d'optimiser la portée de la détection capacitive et de la rendre insensible à son environnement

Dans la présente demande, deux potentiels alternatifs sont identiques à une fréquence donnée lorsqu'ils comportent chacun une composante alternative identique ou similaire à cette fréquence. Ainsi, l'un au moins des deux potentiels identiques à ladite fréquence peut comporter en outre une composante continue, et/ou une composante alternative de fréquence différente de ladite fréquence donnée.

De manière similaire, deux potentiels alternatifs sont différents à la fréquence de travail lorsqu'ils ne comportent pas de composante alternative identique ou similaire à cette fréquence de travail.

Dans la présente demande, le terme « potentiel de masse » ou « potentiel de masse générale » désigne un potentiel de référence de l'électronique, du robot ou de son environnement, qui peut être par exemple une masse électrique ou un potentiel de masse. Ce potentiel de masse peut correspondre à un potentiel de terre, ou à un autre potentiel relié ou non au potentiel de terre.

On rappelle par ailleurs que de manière générale, les objets qui ne sont pas en contact électrique direct avec un potentiel électrique particulier (objets électriquement flottants) tendent à se polariser par couplage capacitif au potentiel électrique d'autres objets présents dans leur environnement, tel que par exemple la terre ou des électrodes, si les surfaces de recouvrement entre ces objets et ceux de l'environnement (ou les électrodes) sont suffisamment importantes.

Dans la présente demande, « objet » désigne tout objet ou personne pouvant se trouver dans l'environnement du robot.

Dans le robot selon l'invention, au moins une sous-partie dudit robot peut ne pas comporter d'électrode de mesure. Dans ce cas, cette sous-partie est dite « non-équipée ».

Alternativement, chaque sous-partie dudit robot peut comporter au moins une électrode de mesure. Dans ce cas, chaque sous-partie est dite « équipée ».

Dans le robot selon l'invention, au moins une sous-partie peut comprendre au moins un organe ou élément électrique agencé dans ladite sous-partie. Dans ce cas, ladite sous-partie est dite « appareillée ». Cet organe ou élément électrique est, de manière générale, électriquement référencé à un potentiel électrique correspondant par exemple au potentiel de référence de son alimentation électrique. Ce potentiel de référence peut être par exemple un potentiel de masse, ou, dans certains modes de réalisation de l'invention, un potentiel de garde.

Un tel organe ou élément électrique peut être ou comprendre un moteur, un capteur, un actionneur, etc. Par exemple, lorsque la sous-partie est une interface articulée, également appelée articulation, alors ladite interface peut comprendre un moteur. Lorsque la sous-partie est un segment, ledit segment peut comporter un module électronique ou un capteur. Lorsque la sous-partie est une tête fonctionnelle, ladite tête fonctionnelle peut comprendre un moteur actionneur d'un outil, un capteur, etc.

La paroi externe d'une sous-partie peut être formée par un ou plusieurs éléments d'habillage.

La paroi externe d'une sous-partie peut être une coque, rigide ou non, de ladite sous-partie.

Avantageusement, au moins une sous-partie appareillée, dont au moins un organe électrique est électriquement gardé au potentiel de garde, peut comprendre un volume ou des parois, de garde :
- disposé(es) autour dudit au moins un organe électrique, et
- polarisé(es) au potentiel de garde par l'au moins un moyen de polarisation.

Autrement dit, dans ce mode de réalisation, l'organe électrique est gardé au potentiel de garde (V_{G}), par le volume (ou les parois) de garde, polarisé audit potentiel de garde.

Un tel volume de garde polarisé au potentiel de garde permet de rendre la ou les organes électriques de la sous-partie invisible pour la fonctionnalité de détection capacitive.

Alternativement, ou en plus, le robot selon l'invention peut comprendre, pour au moins une sous-partie appareillée, au moins un organe électrique électriquement polarisé, ou référencé, au potentiel de garde par l'au moins un moyen de polarisation, de sorte à être gardé électriquement au potentiel de garde.

Le robot selon l'invention peut alors comprendre au moins un convertisseur électrique agencé pour :
- recevoir au moins un signal électrique, dit d'entrée, tel qu'un signal d'alimentation ou de commande, destiné audit au moins un organe électrique, et référencer ledit signal d'entrée au potentiel de garde ; et/ou
- recevoir au moins un signal électrique, dit de sortie, émis par ledit au moins un organe électrique, et référencer ledit signal de sortie au potentiel de masse électrique d'un contrôleur, ou d'un dispositif, auquel il est destiné.

Ainsi, l'organe électrique se trouvant dans la sous-partie appareillée est globalement référencé au potentiel de garde et ne perturbe donc pas la détection capacitive.

Ce mode de réalisation présente l'avantage d'être moins encombrant, moins couteux et plus facile à mettre en place, comparé à l'utilisation d'un volume de garde polarisée au potentiel de garde.

Le convertisseur peut être agencé pour recevoir les signaux d'entrée référencés au potentiel de masse général et les transformer en sortie en signaux référencés au potentiel de garde, et *vice versa.*

Dans le robot selon l'invention, au moins une sous-partie appareillée, dont au moins un organe est gardé au potentiel de garde, peut ne pas être une sous-partie équipée.

Autrement dit, une sous-partie du robot comprenant au moins un organe électrique gardé au potentiel de garde peut ne pas comprendre d'électrodes de détection. Ainsi, même si cette sous-partie n'est pas utilisée pour la détection capacitive, les organes électriques qui sont disposés dans ladite sous-partie ne perturbent pas la détection capacitive.

Alternativement ou en plus, au moins une sous-partie appareillée, dont au moins un organe est gardé au potentiel de garde, peut être une sous-partie équipée.

Autrement dit, une sous-partie du robot, comprenant au moins un organe gardé au potentiel de garde, peut également être équipée d'électrode(s) de détection et participer à la détection capacitive. Dans ce cas, les organes disposés dans cette sous-partie étant gardés au potentiel de garde, ils ne gênent pas la détection capacitive réalisée par cette sous-partie mais aussi toute autre sous-partie du robot équipée d'électrodes de mesure.

Alternativement ou en plus, une sous-partie équipée peut ne pas être appareillée, c'est-à-dire ne pas comprendre d'organe électrique.

Le robot selon l'invention peut en outre comprendre au moins une sous-partie dont la paroi externe est, au moins en partie, électriquement conductrice.

Une telle sous-partie dont la paroi externe est, au moins en partie, conductrice peut être appareillée, ou non.

Une telle sous-partie peut être équipée d'électrodes de mesure, ou non. Dans le cas où des électrodes de mesure sont agencées sur/dans une paroi externe conductrice, alors lesdites électrodes sont isolées de ladite paroi externe conductrice.

De plus, suivant une caractéristique avantageuse, au moins une partie conductrice de la paroi externe d'une sous-partie peut être polarisée au potentiel de garde par l'au moins un moyen de polarisation.

Dans ce cas, ladite sous-partie devient électriquement invisible des électrodes de mesure équipant ladite sous-partie, ou une autre sous-partie, et plus généralement le robot.

Alternativement, ou en plus, au moins une sous-partie dont la paroi externe est, au moins en partie, électriquement conductrice, peut avantageusement être équipée d'électrodes de mesure.

Dans ce cas, ladite paroi externe conductrice polarisée au potentiel de garde forme un plan de garde pour lesdites électrodes de mesure.

Dans la présente demande, une sous-partie peut être, ou comprendre, par exemple, l'un quelconque des éléments suivants pouvant composer un robot :
- un segment de robot,
- une interface mécanique, articulée ou non, disposée entre au moins deux segments de robots,
- une tête fonctionnelle, articulée ou non, formant un outil, ou une tête d'outil, généralement disposée au niveau d'une extrémité distale du robot.

Comme expliqué précédemment, dans la présente demande, par « organe électrique », on entend tout organe électrique pouvant être disposé dans une sous-partie d'un robot, tel qu'un moteur, un capteur, un actionneur, etc.

Par exemple, lorsque la sous-partie est une interface articulée, également appelée articulation, alors l'organe électrique peut être un moteur disposé dans l'articulation. Lorsque la sous-partie est un segment, l'organe électrique peut être un module électronique, un contrôleur ou un capteur disposé dans ledit segment. Lorsque la sous-partie est une tête fonctionnelle, l'organe électrique peut être un moteur actionneur d'un outil, un capteur, etc.

La tête fonctionnelle peut comprendre, ou peut être formée par :
- un moyen de préhension d'un objet, tel qu'une pince ou un étau ;
- un moyen de traitement d'un objet, tel qu'une ponceuse, une perceuse, un pistolet de peinture, etc. ; et/ou
- un moyen d'inspection d'un objet, tel qu'une caméra, une tête d'interférométrie, etc.

Suivant un exemple de réalisation non limitatif, le robot selon l'invention peut comprendre plusieurs segments.

Au moins un segment peut être relié à un autre segment par une interface mécanique articulée, ou non.

Dans une version particulièrement avantageuse, le robot selon l'invention peut comprendre une tête fonctionnelle formée par une sous-partie distale.

Une telle tête fonctionnelle se trouve généralement à une extrémité libre du robot.

Avantageusement, la tête fonctionnelle étant formée par, ou formant, une sous-partie, elle peut présenter chacune des caractéristiques énoncées plus haut pour une sous-partie.

Par exemple, elle peut comporter, ou non, au moins une électrode de mesure, en particulier isolée d'une paroi externe de ladite tête fonctionnelle lorsque ladite paroi est conductrice.

Alternativement ou en plus, elle peut comporter, ou non, au moins un organe électrique disposée dans la tête fonctionnelle.

Alternativement ou en plus, elle peut comporter une paroi externe non-conductrice, ou conductrice d'électricité, au moins partiellement.

Lorsque la paroi externe de la tête fonctionnelle est au moins partiellement conductrice, elle peut être mise au potentiel de garde.

Plus généralement, la tête fonctionnelle peut entièrement être mise au potentiel de garde dans sa totalité.

Suivant une version du robot selon l'invention, la tête fonctionnelle ne forme pas une électrode de détection capacitive. Autrement dit, la tête fonctionnelle n'est pas utilisée comme une électrode de détection capacitive pour détecter la présence ou non d'un objet environnant.

Suivant une autre version, la tête fonctionnelle peut avantageusement être utilisée comme, ou former, une électrode de détection capacitive. Pour ce faire, ladite tête fonctionnelle comporte une paroi externe, au moins en partie, conductrice.

Dans cette version, l'au moins un moyen de polarisation est en outre agencé pour polariser ladite tête fonctionnelle au premier potentiel électrique alternatif, et l'au moins une électronique de détection est agencée pour mesurer un signal relatif à une capacité de couplage entre ladite tête fonctionnelle et un objet environnant.

Le robot selon l'invention peut éventuellement comprendre :
- au moins un isolant électrique pour isoler électriquement ladite tête fonctionnelle du reste dudit robot, et/ou
- au moins une garde, polarisée au potentiel de garde, et disposée entre ladite tête fonctionnelle et le reste dudit robot ;
en particulier lorsque la tête est fixée sur/dans une sous-partie dont la paroi externe est électriquement conductrice ;

Dans cette version, la tête fonctionnelle est utilisée comme électrode capacitive pour réaliser une détection capacitive d'approche ou de contact avec un objet ou une personne environnante. La capacité de couplage générée par la tête fonctionnelle, et en particulier par l'outil ou le porte-outil, du robot selon l'invention, et mesurée par l'électronique de détection, correspond à la capacité créée entre l'environnement et la tête fonctionnelle.

Cette version présente l'avantage de doter la tête d'un robot d'une fonction de détection capacitive d'approche et de contact, sans devoir équiper ladite tête fonctionnelle d'électrodes capacitives. Une telle solution est simple, peu coûteuse, peu chronophage et robuste. De plus, une telle solution peut être appliquée, avec peu de modifications, à un robot existant qui n'a pas été initialement conçu avec une telle fonction de détection.

En outre, lorsque le robot est prévu pour utiliser des têtes fonctionnelles interchangeables, la solution proposée permet d'intervenir sur lesdites têtes fonctionnelles de manière indépendante, sans intervenir sur le reste du robot.

Par ailleurs, un autre avantage de cette version est la possibilité d'utiliser un objet embarqué par la tête fonctionnelle, comme le prolongement de la tête fonctionnelle utilisée comme électrode. En effet, le contact intime entre la tête fonctionnelle et l'objet transporté crée un important couplage capacitif entre eux. La tête fonctionnelle et l'objet qu'elle transporte se retrouvent naturellement à un potentiel électrique similaire. L'objet transporté n'a pas besoin d'être un bon conducteur d'électricité pour se comporter comme le prolongement de la tête fonctionnelle sur le plan de la détection capacitive. Un diélectrique d'un matériau plastique ou polymère dont la permittivité diélectrique est par exemple supérieure à 3 suffit pour devenir le prolongement de la tête fonctionnelle. L'objet transporté fait alors partie de la tête fonctionnelle sensible.

La tête fonctionnelle peut comprendre plusieurs parties sensibles distinctes utilisées comme électrodes capacitives distinctes, et interrogées séquentiellement ou en parallèle par l'électronique de détection. Dans la mesure où ces parties sensibles sont polarisées au même premier potentiel électrique alternatif, elles constituent respectivement des éléments de garde pour les autres et ne se perturbent donc pas. Ces parties sensibles distinctes peuvent être par exemple les doigts d'un outil de préhension.

De plus, le robot selon l'invention peut comprendre au moins un organe électrique disposé dans la tête fonctionnelle, tel qu'un capteur, un actuateur, un moteur, et/ou une électronique associée (conditionneur, driver). Dans ce cas, la tête fonctionnelle est dite appareillée.

Un tel organe électrique peut comprendre, ou être associé à, des fils électriques qui transportent des signaux d'entrée/sortie vers/depuis ledit organe électrique.

Par exemple, la tête fonctionnelle peut utiliser, ou être équipée de, une pince. Celle-ci est généralement gérée par le robot via deux fils d'alimentation pour la puissance et deux fils de communication série pour les commandes et les retours d'information.

Or, par défaut, ces organes électriques sont référencés au potentiel de masse générale (MG), et risquent donc d'être détectés par la partie sensible de la tête fonctionnelle utilisée comme électrode capacitive.

Suivant un mode de réalisation, notamment dans le cas où la tête fonctionnelle est utilisée comme électrode de détection capacitive, pour au moins un organe disposé dans la tête fonctionnelle, ladite tête fonctionnelle peut comprendre un volume, ou des parois, de garde, disposé(es) autour dudit au moins un organe électrique, et polarisé(es) au potentiel de garde, à la fréquence de travail.

Suivant un autre mode de réalisation, notamment dans le cas où la tête fonctionnelle est utilisée comme électrode de détection capacitive, le robot selon l'invention peut comprendre, dans la tête fonctionnelle, au moins un organe électrique électriquement polarisé, ou référencé, au potentiel de garde par l'au moins un moyen de polarisation, de sorte à être gardé électriquement au potentiel de garde.

Dans ce cas, le robot selon l'invention peut comprendre en outre au moins un convertisseur électrique agencé pour :
- recevoir au moins un signal électrique, dit d'entrée, tel qu'un signal d'alimentation ou de commande, destiné audit au moins un organe électrique, et référencer ledit signal d'entrée au potentiel de garde ; et/ou
- recevoir au moins un signal électrique, dit de sortie, émis par ledit au moins un organe électrique, et référencer ledit signal de sortie au potentiel de masse électrique d'un contrôleur auquel il est destiné.

Ainsi, l'organe électrique se trouvant dans la tête fonctionnelle est globalement référencé au potentiel de garde et ne perturbe donc pas la détection capacitive.

Ce mode de réalisation présente l'avantage d'être moins encombrant, moins couteux et plus facile à mettre en place.

Le convertisseur peut être agencé pour recevoir les signaux d'entrée référencés au potentiel de masse général et les transformer en sortie en signaux référencés au potentiel de garde, et *vice versa.*

Le convertisseur peut être dédié à la tête fonctionnelle.

Alternativement, le convertisseur peut être commun à au moins une autre sous-partie appareillée pour laquelle une fonctionnalité de conversation de potentiel de référence est mise en œuvre, tel que décrit plus haut.

Suivant un mode de réalisation, tous les organes électriques agencés dans le robot selon l'invention peuvent être électriquement être gardés au potentiel de garde (V_{G}), au travers d'un unique, ou de plusieurs, convertisseur(s), ou au travers d'un unique ou de plusieurs volumes de garde.

Suivant des exemples de réalisation, un tel convertisseur peut comprendre au moins l'un des éléments suivants :
- au moins une alimentation à isolation galvanique, telle qu'un convertisseur DC/DC, en particulier pour générer un signal d'entrée d'alimentation pour ledit au moins un organe électrique ;
- au moins une interface électrique sans contact galvanique, de type capacitive ou par opto-coupleur, pour au moins un signal d'entrée de commande, ou au moins un signal de sortie ;
- une ou plusieurs inductances à impédance élevée pour recevoir et transmettre au moins un signal d'entrée ou au moins un signal de sortie;
- au moins un convertisseur à transfert de charges, ou à pompe de charge, à base de capacités commutées ; et/ou
- des dispositifs à diode.

Il est à noter que dans la mesure où la détection du couplage capacitif est réalisée à une fréquence de travail, les signaux électriques d'entrée/sortie concernant les organes électriques du robot ne perturbent pas la mesure de la capacité de couplage car ils sont rejetés ou filtrés par l'électronique de détection capacitive. Cela est d'autant plus efficace, dans le cas d'une démodulation synchrone du signal mesurée par l'électronique de détection.

Le moyen de polarisation électrique peut avantageusement comprendre un oscillateur qui génère une tension alternative d'excitation utilisée comme premier potentiel électrique alternatif.

Cette tension alternative d'excitation peut être également utilisée comme potentiel de garde (V_{G}).

Le robot selon l'invention peut comprendre un moyen de polarisation unique.

Alternativement, le robot selon l'invention peut comprendre un moyen de polarisation dédié à un segment, une articulation ou à la tête fonctionnelle.

L'électronique de détection peut avantageusement comprendre un circuit comprenant un amplificateur de courant ou de charge. Un tel amplificateur peut être réalisé par un amplificateur opérationnel et une capacité de contre-réaction.

Suivant des modes de mise en oeuvre préférentiels, l'électronique de détection, et en particulier l'amplificateur opérationnel, peuvent être alimentés à un potentiel référencé au potentiel de garde.

Suivant d'autres modes de mise en œuvre, l'électronique de détection peut être alimentée à un potentiel référencé au potentiel de masse générale.

L'électronique de détection peut en outre comprendre un conditionneur ou des moyens de conditionnement permettant d'obtenir un signal représentatif de la capacité électrode-objet recherchée, et/ou de la présence ou de la proximité d'un objet.

Ce conditionneur peut comprendre par exemple un démodulateur synchrone pour démoduler le signal par rapport à une porteuse, à une fréquence de travail.

Le conditionneur peut également comprendre un démodulateur asynchrone ou un détecteur d'amplitude.

Ce conditionneur peut bien entendu être réalisé sous une forme analogique et/ou numérique (microprocesseur) et comprendre tous moyens nécessaires de filtrage, conversion, traitement, etc.

Les signaux de mesure capacitive, en particulier les signaux issus du conditionneur le cas échéant, peuvent ensuite être traités par un logiciel ou un module de gestion, qui permet de gérer la détection d'approche et de toucher, et en particulier d'exploiter ces informations en fonction du contexte d'utilisation du robot.

Un tel logiciel, ou module de calcul, peut par exemple être intégré à un calculateur ou contrôleur, du robot.

A titre d'exemple, le robot selon l'invention peut facilement détecter une main humaine à plus de 10 cm de distance.

Le robot selon l'invention peut comprendre une électronique de détection unique.

Alternativement, le robot selon l'invention peut comprendre une électronique de détection dédiée à une sous-partie, telle qu'un segment, une articulation ou à la tête fonctionnelle.

Suivant des modes de réalisation, tous les organes électriques agencés dans le robot selon l'invention peuvent être électriquement gardés au potentiel de garde.

L'électronique de détection et/ou le moyen de polarisation, peu(ven)t être disposé(s) en partie, ou en totalité, dans le corps du robot.

Alternativement, l'électronique de détection et/ou le moyen de polarisation, peu(ven)t être disposé(s) hors du robot et relié(s) audit robot par une ou des liaisons électriques.

Suivant des exemples de réalisation nullement limitatifs, le robot selon l'invention peut être ou comprendre tout système robotisé. Il peut en particulier se présenter sous la forme de, ou comprendre, un bras robotisé.

Le robot peut également être ou comprendre par exemple un robot mobile, un véhicule sur roues ou chenilles tel qu'un chariot muni d'un bras ou d'un système manipulateur, ou un robot de type humanoïde, gynoïde ou androïde, éventuellement pourvu d'organes de déplacement tels que des membres.

Le robot peut ainsi comprendre une garde réalisée par au moins une partie, ou la totalité, du corps du robot selon l'invention, polarisée au potentiel de garde.

En effet, il est possible de polariser une partie importante, ou la totalité du corps du robot au potentiel de garde. Lorsque le robot est un bras robotisé, il est possible de polariser une partie importante, voire la totalité, du bras au potentiel de garde et de l'utiliser comme garde.

Dans ce cas, un circuit électronique convertisseur, dit circuit d'interface, est interfacé entre le circuit électrique de cette partie polarisée à la garde du robot, et le circuit électrique du reste du robot référencé à la masse générale. Ce circuit d'interface génère l'excitation de l'électronique capacitive référencée à la garde, et assure l'interface entre l'électronique de la partie polarisée à la garde du robot, et l'électronique référencée à la masse (alimentation, communication, etc.) du reste du robot. Ce circuit d'interface peut être logé au niveau de la partie référencée à la garde du robot, ou au niveau de la partie référencée au potentiel de masse du robot.

Lorsqu'une partie, ou l'ensemble du robot, est recouvert(e) d'électrodes capacitives, et que la partie du robot supportant ces électrodes est référencée au potentiel de la garde, la structure du robot au niveau de cette partie peut en être simplifiée car il n'est pas nécessaire d'intercaler une garde supplémentaire entre le robot et ces électrodes capacitives. Ces électrodes et la tête fonctionnelle peuvent alors être référencées au même potentiel de garde, ce qui évite toute interférence.

### Description des figures et modes de réalisation

D'autres avantages et caractéristiques apparaîtront à l'examen de la description détaillée d'exemples nullement limitatifs, et des dessins annexés sur lesquels :
- la FIGURE 1 est une représentation schématique d'un exemple de robot d'art antérieur équipé d'électrodes de détection capacitives ;
- les FIGURES 2-5 sont des représentations schématiques de différents exemples de réalisation d'un robot selon l'invention ;
- les FIGURES 6-11 sont des représentations schématiques partielles de différents exemples d'une tête fonctionnelle pouvant équiper un robot selon l'invention ; et
- la FIGURE 12 est une représentation schématique d'un exemple de réalisation d'une électronique de détection pouvant être mise en oeuvre dans un robot selon l'invention.

Il est bien entendu que les modes de réalisation qui seront décrits dans la suite ne sont nullement limitatifs. On pourra notamment imaginer des variantes de l'invention ne comprenant qu'une sélection de caractéristiques décrites par la suite isolées des autres caractéristiques décrites, si cette sélection de caractéristiques est suffisante pour conférer un avantage technique ou pour différencier l'invention par rapport à l'état de la technique antérieur. Cette sélection comprend au moins une caractéristique de préférence fonctionnelle sans détails structurels, ou avec seulement une partie des détails structurels si cette partie uniquement est suffisante pour conférer un avantage technique ou pour différencier l'invention par rapport à l'état de la technique antérieur.

En particulier toutes les variantes et tous les modes de réalisation décrits sont combinables entre eux si rien ne s'oppose à cette combinaison sur le plan technique.

Sur les figures, les éléments communs à plusieurs figures conservent la même référence.

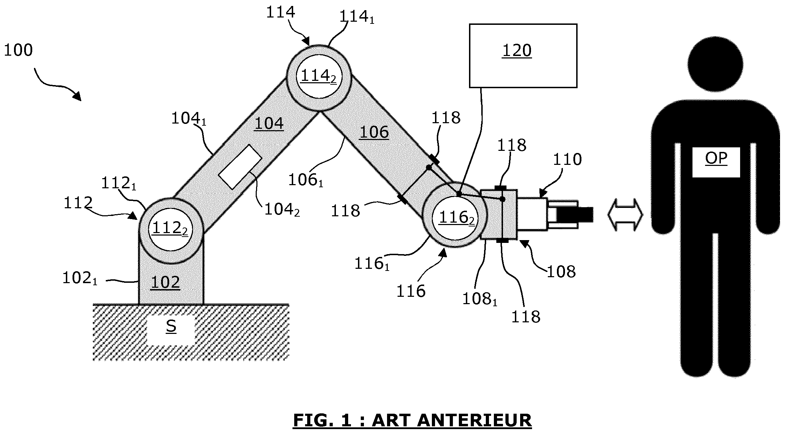

La FIGURE 1 est une représentation schématique d'un exemple de réalisation d'un robot selon l'art antérieur, équipé d'électrodes capacitives.

Le bras robotisé 100 peut être, par exemple, un robot collaboratif industriel travaillant sous la surveillance, ou en collaboration avec, un opérateur OP, ou encore un robot médical en vue d'une intervention sur le corps d'une personne, ou encore un robot d'assistance à la personne.

Le robot 100, représenté sur la FIGURE 1, se présente sous la forme d'un bras robotisé articulé comprenant huit sous-parties 102-116, à savoir :
- quatre segments 102, 104, 106 et 108 ;
- une tête fonctionnelle 110 ; et
- trois interfaces mécaniques 112, 114 et 116.

Le segment 102 est le segment de base fixé à un support S, qui peut être le sol. Le segment 108 est le segment se trouvant du côté d'une extrémité libre du robot 100. Chaque segment 102-108 est délimité par une paroi externe ou coque, respectivement 102₁-108₁, réalisée par la surface d'un élément de la structure du segment, ou par un ou plusieurs éléments de couverture, par exemple en matière plastique (polymère) ou métallique(s). Généralement, chaque segment 102-108 est creux et permet de disposer dans ledit segment des organes électriques ou électroniques.

La tête fonctionnelle 110 se trouve du côté du segment 108, et forme un outil ou un porte-outil, qui dans l'exemple représenté est une pince.

Les segments 102-108 sont articulés grâce aux interfaces mécaniques articulées 112-116, également appelées « articulations » dans la suite. L'articulation 112 se trouve entre les segments 102 et 104, l'articulation 114 se trouve entre les segments 104 et 106, et l'articulation 116 se trouve entre les segments 106 et 108. Chaque articulation 112-116 comporte une paroi externe ou coque, respectivement 112₁-116₁, réalisée en un ou plusieurs éléments de couverture, par exemple en matière plastique (polymère) ou métallique(s).

Chacune des articulations 112-116 est une articulation rotative selon un axe. Alternativement, au moins une articulation 112-116 peut, en plus ou à la place, être une articulation de translation, et/ou une articulation en rotation avec plusieurs axes.

Les segments articulés 106 et 108 sont équipés d'une ou plusieurs électrodes de détection capacitives 118, dites électrodes de mesure. Chaque électrode de mesure 118 équipant le segment 106, respectivement le segment 108, est électriquement isolée de la paroi externe 106₁, respectivement 108₁, de ce segment.

Un module électronique 120 est associé au robot 100. Ce module électronique 120 comprend :
- une électronique de polarisation polarisant chaque électrode de mesure 118 à un premier potentiel alternatif, différent d'un potentiel de masse générale (MG), à une fréquence de travail non nulle ; et
- une électronique de mesure pour mesurer un signal électrique, et en particulier un courant électrique, pour chacune des électrodes de mesure 118 en vue d'en déduire une capacité, dite électrode-objet, résultant d'un couplage capacitif entre l'électrode de mesure et un objet dans son voisinage électriquement polarisé à la masse générale (MG) ou au moins à un potentiel différent du premier potentiel alternatif, et représentative d'une distance entre ladite électrode de mesure 118 et un objet environnant.

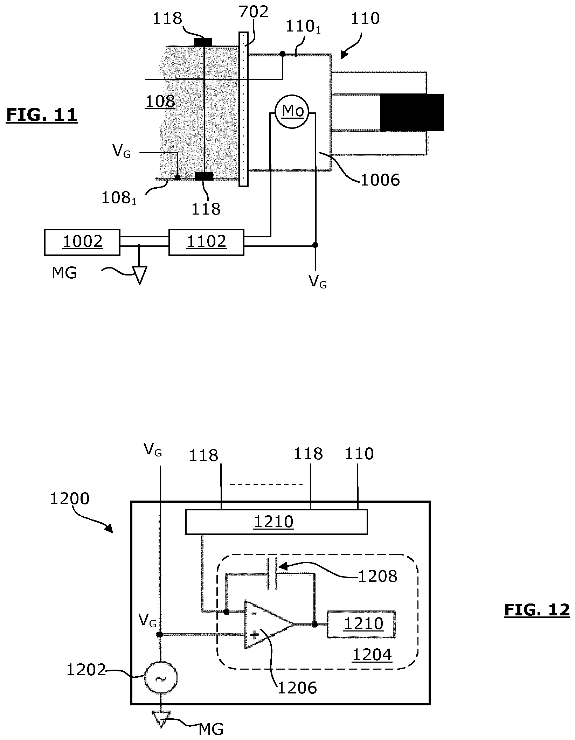

Un exemple de module 120 sera décrit plus loin en référence à la FIGURE 12.

Chaque électrode de mesure 118 est en outre, de préférence, gardée par une électrode, dite de garde, (non représentée) polarisée à un potentiel alternatif de garde, notée V_{G}, identique ou sensiblement identique au premier potentiel, à la fréquence de travail et disposée selon la face arrière de l'électrode, par exemple entre la paroi du segment et l'électrode de mesure 118.

Ainsi, le robot 100 peut détecter un objet se trouvant dans son environnement grâce aux électrodes de mesure 118.

Dans l'exemple représenté, chaque articulation 112-116 comporte un moteur, respectivement 112₂-116₂. Lorsque l'une des articulations 112-114 comportent une coque externe 112₁-116₁ électriquement non-conductrice, dans certaines configurations, les électrodes de mesure 118 détectent également le moteur 112₂-114₂ se trouvant dans cette articulation. En effet, chaque moteur électrique 112₂-114₂ étant référencé à un potentiel de masse générale (MG), alors il est détecté comme étant un objet externe, au même titre que l'opérateur OP. Par exemple, lorsque l'un des segments équipés 106 ou 108, s'approche de l'articulation 112, respectivement 114 ou 116, alors les électrodes de mesure 118 équipant ce segment détecte le moteur 112₂, respectivement 1142 ou 1162, se trouvant dans cette articulation comme étant un objet environnant, alors que ce n'est pas le cas.

De plus, dans l'exemple représenté le segment 104 comporte un module électronique 104₂ référencé à un potentiel de masse générale (MG). Si le segment 104 comporte une coque externe 104₁ non conductrice électriquement, dans certaines configurations, les électrodes de mesure 118 détectent également le module électronique 104₂ se trouvant dans ce segment 104. En effet, le module électronique 104₂ étant référencé à un potentiel de masse générale (MG), alors il est détecté comme étant un objet externe, au même titre que l'opérateur OP. Par exemple, lorsque l'un des segments équipés 106 ou 108, s'approche du segment 104, alors les électrodes de mesure 118 équipant ce segment détecte le module électronique 104₂ se trouvant dans ce segment 104 comme étant un objet environnant, alors que ce n'est pas le cas.

Ces auto-détections diminuent l'amplitude de fonctionnement du robot 100 et pénalisent son fonctionnement.

Pour pallier ces inconvénients, l'invention propose de garder à un potentiel de garde alternatif V_{G} identique, ou sensiblement identique, au premier potentiel à la fréquence de travail, au moins un organe électrique se trouvant dans une sous-partie du robot dont la coque externe n'est pas électriquement conductrice.

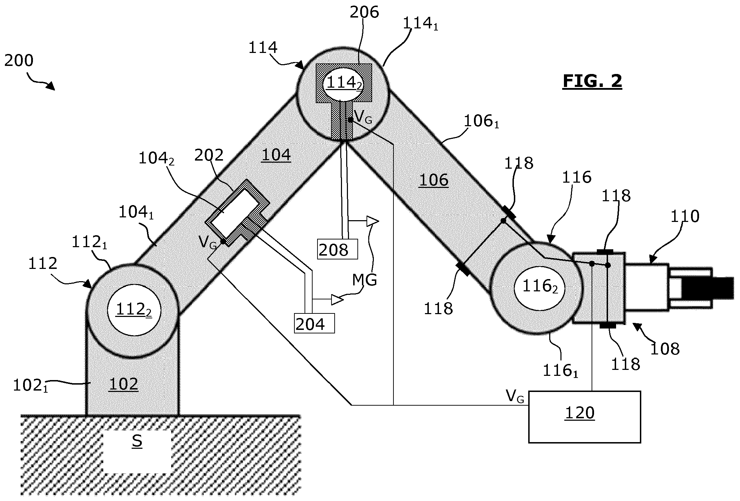

La FIGURE 2 est une représentation schématique d'un exemple de réalisation non limitatif d'un robot selon l'invention.

Le robot 200, représenté sur la FIGURE 2, comprend tous les éléments du robot 100 de la FIGURE 1.

Dans l'exemple représenté sur la FIGURE 2, on considère que la coque 104₁ du segment 104 est électriquement non-conductrice. De même, on considère que la coque 114₁ de l'articulation 114 est électriquement non-conductrice.

Dans le robot 200, le module électrique 104₂, référencé à un potentiel électrique de masse générale MG, ainsi que ses connecteurs électriques sont disposés dans un volume de garde 202, polarisé à un potentiel de garde V_{G} identique, ou sensiblement identique, au premier potentiel alternatif à la fréquence de travail. Ainsi, le module électronique 104₂ et les connecteurs qui lui sont associés, ne sont pas visibles par les électrodes de mesure 118 et ne perturbent pas la détection capacitive réalisée par lesdites électrodes de mesure 118, tout en continuant à recevoir/émettre, des signaux électriques référencés au potentiel de masse générale MG depuis/vers un contrôleur, ou un dispositif, 204.

De manière similaire, dans le robot 200, le moteur électrique 114₂, référencé à un potentiel électrique de masse générale MG, ainsi que ses connecteurs électriques et son électronique, sont disposés dans un volume de garde 206, polarisé à un potentiel de garde V_{G} identique ou sensiblement identique au premier potentiel alternatif à la fréquence de travail. Ainsi, le moteur électrique 114₂, ses connecteurs et son électronique, ne sont pas visibles par les électrodes de mesure 118 et ne perturbent pas la détection capacitive réalisée par lesdites électrodes de mesure 118, tout en continuant à recevoir/émettre, des signaux électriques référencés au potentiel de masse générale MG depuis/vers un contrôleur 208.

Comme pour le moteur 114₂, il est également possible de disposer, dans un volume de garde, le moteur électrique 112₂, respectivement 116₂, (ainsi que ses connecteurs électriques et son électronique) agencé dans l'articulation 112, respectivement 116, si la coque 112₁, respectivement 116₁, de cette articulation est électriquement non-conductrice, ou isolante.

De manière générale, tous les organes, disposés dans le robot 200, peuvent agencés dans un volume de garde polarisé au potentiel de garde, en particulier lorsque ces organes sont disposés dans une sous-partie dont la coque n'est pas conductrice d'électricité.

Les volumes de garde sont réalisés par exemple par un ensemble de parois conductrices polarisées au potentiel de garde V_{G} et entourant respectivement les moteurs électriques ou les modules électriques.

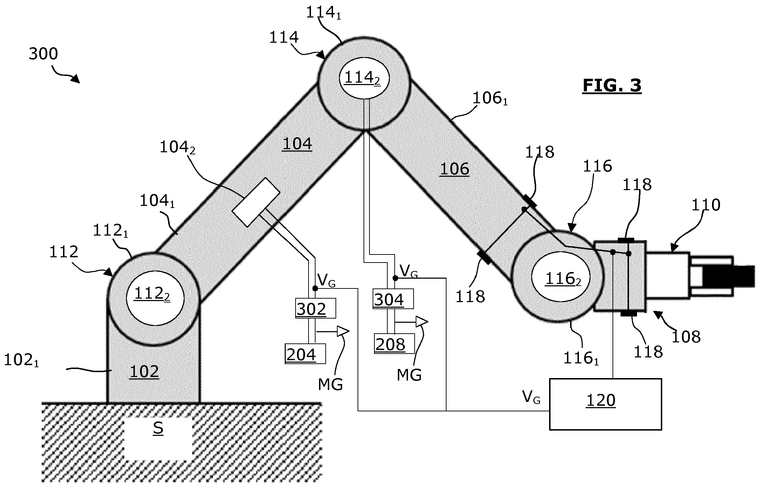

La FIGURE 3 est une représentation schématique d'un exemple de réalisation non limitatif d'un robot selon l'invention.

Le robot 300, représenté sur la FIGURE 3, comprend tous les éléments du robot 100 de la FIGURE 1.

Dans l'exemple représenté sur la FIGURE 3, on considère que la coque 104₁ du segment 104 est électriquement non-conductrice, ou isolante. De même, on considère que la coque 114₁ de l'articulation 114 est électriquement non-conductrice, ou isolante.

Dans le robot 300, à la place du volume de garde 202 de la FIGURE 2, un convertisseur de potentiel 302 est utilisé. Ce convertisseur 302 est disposé entre le contrôleur 204 et le module électronique 104₂. Ce convertisseur 302 a pour fonction de :
- recevoir au moins un signal électrique, dit d'entrée, tel qu'un signal d'alimentation ou de commande, émis par le contrôleur 204 et destiné au module 104₂, et référencer ledit signal d'entrée au potentiel de garde V_{G} ; et
- recevoir au moins un signal électrique, dit de sortie, émis par ledit module 104₂ et destiné au contrôleur 204, et référencer ledit signal de sortie au potentiel de masse générale MG du contrôleur 204.

Ainsi le module électronique 104₂, tout comme les connecteurs qui lui sont associés, reçoivent et émettent des signaux référencés au potentiel de garde V_{G} et ne perturbent pas les électrodes de détection du robot 300.

De manière similaire, à la place du volume de garde 206 de la FIGURE 2, un convertisseur de potentiel 304 est utilisé. Ce convertisseur 304 est disposé entre le contrôleur 208 et le moteur électrique 114₂. Ce convertisseur 304 a pour fonction de :
- recevoir au moins un signal électrique, dit d'entrée, tel qu'un signal d'alimentation ou de commande, émis par le contrôleur 208 et destiné au moteur électrique 114₂, et référencer ledit signal d'entrée au potentiel de garde V_{G} ; et
- recevoir au moins un signal électrique, dit de sortie, émis par ledit moteur électrique 114₂ et destiné au contrôleur 208, et référencer ledit signal de sortie au potentiel de masse générale MG du contrôleur 208.

Ainsi le moteur électrique 114₂, tout comme les connecteurs et l'électronique qui lui sont associés, reçoivent et émettent des signaux référencés au potentiel de garde V_{G} et ne perturbent pas les électrodes de détection du robot 300.

Comme pour le moteur 114₂, il est également possible d'utiliser un convertisseur de potentiel pour le moteur électrique 112₂, respectivement 116₂ (ainsi que ses connecteurs électriques et son électronique), si la coque 112₁, respectivement 116₁, de cette articulation est isolante.

De manière générale, tous les organes, disposés dans le robot 300, peuvent être associés à un convertisseur de potentiel, en particulier lorsque ces organes sont disposés dans une sous-partie dont la coque n'est pas conductrice d'électricité.

Dans l'exemple de la FIGURE 3, deux convertisseurs de potentiels indépendants sont utilisés. Bien entendu, il est possible d'utiliser un unique convertisseur de potentiel commun à plusieurs, voire tous les organes disposés dans le robot 300.

De plus, il est possible de combiner les modes de réalisation des FIGURES 2 et 3. Par exemple, il est possible de disposer un organe électrique dans un volume de garde et d'alimenter un autre organe électrique au travers d'un convertisseur de potentiel.

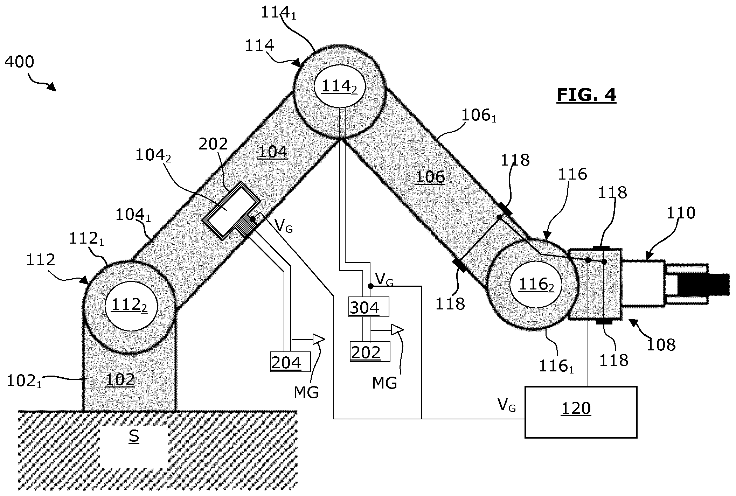

La FIGURE 4 est une représentation schématique d'un tel exemple de réalisation.

Dans le robot 400 de la FIGURE 4, le module électronique 104₂ est disposé dans le volume de garde 202, comme sur la FIGURE 2. De plus, les signaux sont échangés avec le moteur électrique 114₂ au travers du convertisseur de potentiel 304, comme sur la FIGURE 3, sans utilisation d'un volume de garde pour le moteur 114₂.

Dans les exemples des FIGURES 2-4, le segment 106, respectivement 108, équipé d'électrodes de mesure 118 ne comporte pas d'organe.

Bien entendu, ce segment 106, respectivement 108, peut aussi comprendre au moins un organe électrique. Dans ce cas, et si la coque 106₁, respectivement 108₁, de ce segment est non conductrice d'électricité, alors l'organe électrique disposé dans le segment 106, respectivement 108, peut être soit agencé dans un volume de garde, soit associé à un convertisseur de potentiel, tels que décrit plus haut.

De plus, dans les exemples des FIGURES 2-4, le segment 104 et l'articulation 114 ne sont pas équipés d'électrodes de mesure. Bien entendu, ce segment 104, et/ou cette articulation 116 peut aussi être équipé(e) d'électrodes de mesure.

De manière générale, lorsqu'une sous-partie d'un robot comporte une paroi externe non conductrice d'électricité et que cette sous-partie comporte un organe électrique, il est possible :
- de disposer ledit organe dans un volume de garde, ou
- d'utiliser un convertisseur de potentiel pour cet organe électrique Une telle sous-partie peut être équipée, ou non, d'électrodes de mesure.

Une telle sous-partie peut être un segment, une articulation, ou une tête fonctionnelle se présentant sous la forme d'un outil ou d'un porte-outil.

En outre, il est possible qu'un robot soit constitué de plusieurs sous-parties dont certaines comportent une paroi externe non-conductrice d'électricité et d'autre comportent une paroi externe conductrice d'électricité, au moins en partie.

Or, la paroi externe conductrice d'électricité d'un robot est détectée par les électrodes de mesure, si cette paroi n'est pas au potentiel de garde V_{G} à la fréquence de travail.

Une telle auto-détection diminue l'amplitude de fonctionnement du robot et pénalise son fonctionnement.

L'invention permet également de pallier cet inconvénient.

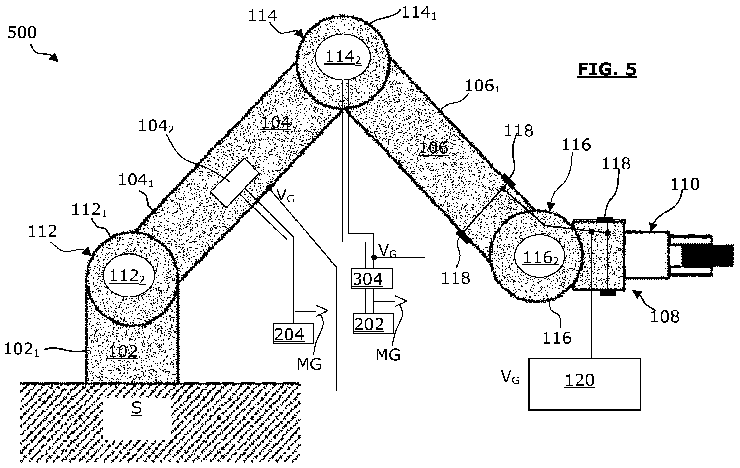

La FIGURE 5 est une représentation schématique d'un autre exemple de réalisation non limitatif d'un robot selon l'invention.

Le robot 500, représenté sur la FIGURE 5, comprend tous les éléments du robot 100 de la FIGURE 1.

Dans l'exemple représenté sur la FIGURE 5, on considère que la coque 104₁ du segment 104 est électriquement conductrice. On considère, par ailleurs, que la coque 114₁ de l'articulation 114 est électriquement non-conductrice.

Dans ces conditions, pour éviter que les électrodes de mesure 118 ne détectent le moteur électrique 114₂, le robot 500 met en oeuvre le convertisseur de potentiel 304 tel que décrit en référence à la FIGURE 4, par exemple.

De plus, pour éviter que les électrodes de mesure 118 ne détectent la coque électriquement conductrice 104₁ du segment 104, ladite coque 104₁ est polarisée au potentiel de garde V_{G}. Ainsi, la coque 104₁, et par conséquent le segment 104, devient électriquement invisible pour les électrodes de mesure 118.

D'une manière générale, lorsqu'une sous-partie d'un robot comporte une paroi externe conductrice d'électricité, alors il est possible de polariser ladite paroi externe au potentiel de garde V_{G} de sorte que ladite coque conductrice ne soit détectée par les électrodes de mesure.

Une telle sous-partie peut être une sous-partie comprenant, ou ne comprenant pas, d'organe électrique.

Une telle sous-partie peut être équipée, ou non, d'électrodes de mesure. Si les électrodes de mesure sont sur une paroi externe conductrice polarisée au potentiel de garde V_{G}, il n'est pas nécessaire d'intercaler un plan de garde sous ces électrodes.

Une telle sous-partie peut être un segment, une articulation, ou une tête fonctionnelle se présentant sous la forme d'un outil ou d'un porte-outil.

Nous allons maintenant décrire des exemples de tête fonctionnelle pouvant être mise en oeuvre dans le robot selon l'invention, en particulier en combinaison avec l'un quelconque des robots 200, 300, 400 et 500 décrits plus haut.

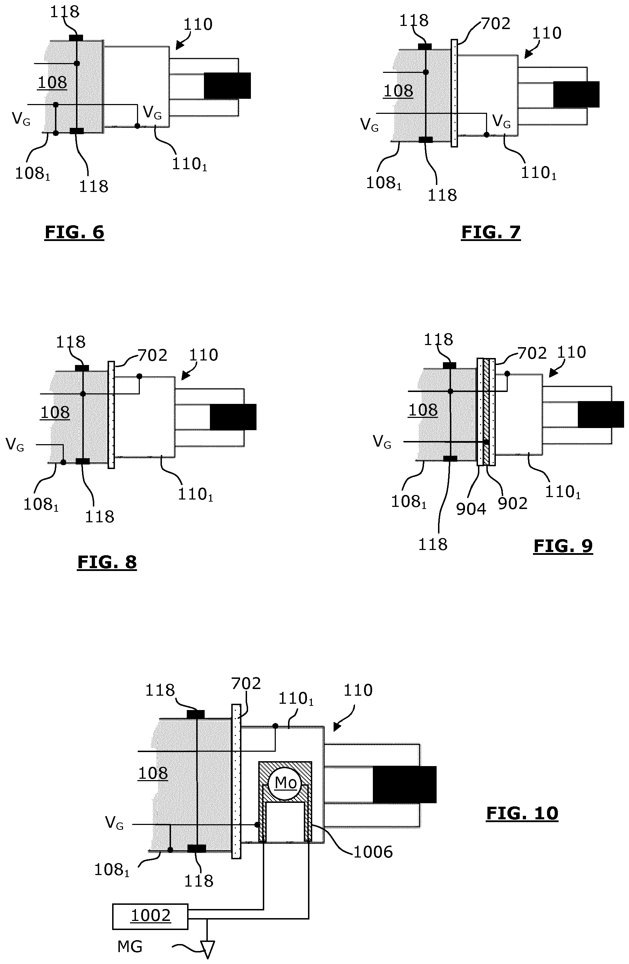

La FIGURE 6 est une représentation schématique d'un exemple de tête fonctionnelle pouvant être mise en œuvre dans un robot selon l'invention, en particulier dans l'un quelconque des robots des FIGURES 2-5.

Dans l'exemple représenté sur la FIGURE 6, la paroi externe 108₁ du segment 108 sur lequel est fixée la tête fonctionnelle 110 est conductrice d'électricité et est polarisée au potentiel de garde V_{G}.

De plus, la tête fonctionnelle, ou la paroi externe 110₁ de la tête fonctionnelle 110, est également conductrice d'électricité et est mise au potentiel de garde V_{G}.

Ainsi, la tête fonctionnelle 110 est électriquement invisible des électrodes de mesure 118 équipant les segments 106 et 108. Dans cette configuration, il n'y a donc pas de risque que les électrodes de mesure 118 détectent la tête fonctionnelle.

Suivant une version alternative, la paroi externe 108₁ du segment 108 peut ne pas être conductrice et ne pas être mise au potentiel de garde V_{G}.

La FIGURE 7 est une représentation schématique d'un autre exemple de tête fonctionnelle pouvant être mise en œuvre dans un robot selon l'invention, en particulier dans l'un quelconque des robots des FIGURES 2-5.

Dans l'exemple représenté sur la FIGURE 6, la paroi externe 108₁ du segment 108 sur lequel est fixé la tête fonctionnelle 110 n'est pas polarisée au potentiel de garde V_{G}.

Dans le même temps, la tête fonctionnelle 110, ou la paroi externe 110₁ de la tête fonctionnelle 110, est polarisée au potentiel de garde V_{G}. De plus, un isolant électrique 702 est inséré entre le segment 108 et la tête fonctionnelle 110 de sorte que la tête fonctionnelle 110 est électriquement isolée du segment 108.

Dans ces conditions, la tête fonctionnelle 110 est électriquement invisible des électrodes de mesure 118 équipant les segments 106 et 108. Dans cette configuration, il n'y a donc pas de risque que les électrodes de mesure 118 détectent la tête fonctionnelle.

Suivant une version alternative, lorsque la paroi externe 108₁ du segment 108 n'est pas conductrice, il n'est pas nécessaire d'utiliser l'isolant 702.

La FIGURE 8 est une représentation schématique d'un autre exemple de tête fonctionnelle pouvant être mise en œuvre dans un robot selon l'invention, en particulier dans l'un quelconque des robots des FIGURES 2-5.

Dans l'exemple représenté sur la FIGURE 8, la paroi externe 108₁ du segment 108 sur lequel est fixée la tête fonctionnelle 110 est polarisée au potentiel de garde V_{G}
La tête fonctionnelle 110 est électriquement isolée du segment 108 par l'isolant électrique 702.

De plus, la tête fonctionnelle 110 est polarisée au premier potentiel alternatif, à l'instar des électrodes de mesure 118 de sorte à former une électrode de détection capacitive. La paroi 108₁ du segment 108 étant au potentiel de garde V_{G}, l'électrode de détection formée par la tête fonctionnelle 110 est électriquement gardée par ladite paroi externe 108₁ du segment 108.

Dans ces conditions, la tête fonctionnelle 110 est utilisée comme une électrode de détection capacitive pour détecter des objets ou la personne 102, présents dans une zone de détection tout autour de la tête fonctionnelle 110.

Le module 120 permet de mesurer un signal électrique, et en particulier un courant électrique, relatif à une capacité de couplage, dite capacité électrode-objet, et notée Cₑₒ, entre la tête fonctionnelle 110 et son environnement.

Suivant une version alternative, la paroi externe 108₁ du segment 108 peut être conductrice et ne pas être polarisée au potentiel de garde V_{G}.

Suivant encore une autre alternative, la paroi externe 108₁ du segment 108 peut pas être conductrice et ne pas être mise au potentiel de garde V_{G}. Dans ce cas, il n'est pas nécessaire d'utiliser l'isolant 702.

La FIGURE 9 est une représentation schématique d'un autre exemple de tête fonctionnelle pouvant être mise en œuvre dans un robot selon l'invention, en particulier dans l'un quelconque des robots des FIGURES 2-5.

Dans l'exemple représenté sur la FIGURE 9, la paroi externe 108₁ du segment 108 sur lequel est fixée la tête fonctionnelle 110 n'est pas polarisée au potentiel de garde V_{G}.

La tête fonctionnelle 110 est polarisée au premier potentiel alternatif, à l'instar des électrodes de mesure 118.

De plus, un élément de garde 902, polarisé au potentiel de garde V_{G}, est disposé entre la tête fonctionnelle 110 et le segment 108. Cet élément de garde 902 permet de garder électriquement la tête fonctionnelle 110 utilisée comme électrode de détection capacitive.

L'élément de garde 902 est électriquement isolé de la tête fonctionnelle 110 par l'isolant électrique 702 et du segment 108 par un isolant électrique 904.

Dans ces conditions, la tête fonctionnelle 110 est utilisée comme une électrode de détection capacitive gardée par l'élément de garde 902 pour détecter des objets ou la personne 102, présents dans une zone de détection tout autour de la tête fonctionnelle 110.

L'élément de garde 902 peut être réalisé par tout élément électriquement conducteur, tel que par exemple une pièce de tôle. L'élément de garde 902 peut être plan, ou peut avoir une forme en manchon venant recouvrir une partie du segment 108 ou de la tête fonctionnelle 110.

Suivant encore une autre alternative, la paroi externe 108₁ du segment 108 peut pas être conductrice. Dans ce cas, il n'est pas nécessaire d'utiliser les isolants 702 et 904, ni la garde 902.

Dans les exemples des FIGURES 8 et 9, la tête fonctionnelle est polarisée au premier potentiel électrique et est utilisée comme électrode de détection capacitive.

Cependant, dans certaines configurations, la tête fonctionnelle peut comprendre un organe électrique, tel qu'un moteur un capteur, etc. recevant un signal d'entrée et/ou émettant un signal de sortie. Dans cette configuration, un tel organe électrique vient perturber la détection capacitive réalisée par la tête fonctionnelle.

Nous allons maintenant décrire des exemples permettant de résoudre cette problématique.

La FIGURE 10 est une représentation schématique d'un autre exemple de tête fonctionnelle pouvant être mise en œuvre dans un robot selon l'invention, en particulier dans l'un quelconque des robots des FIGURES 2-5.

Dans l'exemple représenté sur la FIGURE 10, la tête fonctionnelle 110 comprend tous les éléments de la tête fonctionnelle de la FIGURE 8.

De plus, la tête fonctionnelle 110 comprend un organe électrique, qui dans l'exemple présent est un moteur Mo permettant de bouger les pinces de la tête fonctionnelle 110.

Le moteur électrique Mo reçoit un signal d'alimentation depuis, et éventuellement émet un signal de sortie permettant de déterminer la position des pinces vers, un contrôleur 1002 qui peut être un contrôleur du robot. Généralement ces signaux d'entrée/sortie sont référencés à un potentiel de masse électrique générale MG. Or, lorsque la tête fonctionnelle 110 est utilisée comme électrode de détection capacitive, alors le moteur Mo ainsi que les lignes électriques conduisant les signaux d'entrée/sortie, référencés au potentiel de masse générale MG, viennent perturber la détection réalisée par la tête fonctionnelle 110.

Pour éviter cette perturbation, le moteur Mo, ainsi que les connecteurs et l'électronique qui lui sont associés, sont disposés dans un volume de garde 1006 polarisé au potentiel de garde V_{G}. Ainsi, le moteur électrique Mo, et les connecteurs et l'électronique qui lui sont associés, ne sont pas visibles par la tête fonctionnelle 110 et ne perturbent pas la détection capacitive réalisée par ladite tête fonctionnelle 110.

Bien entendu, un tel volume de garde peut aussi être utilisé en combinaison avec le mode de réalisation de la FIGURE 9.

La FIGURE 11 est une représentation schématique d'un autre exemple de tête fonctionnelle pouvant être mise en œuvre dans un robot selon l'invention, en particulier dans l'un quelconque des robots des FIGURES 2-5.

Dans l'exemple représenté sur la FIGURE 10, la tête fonctionnelle 100 comprend tous les éléments de la tête fonctionnelle de la FIGURE 10 sauf le volume de garde 1006.

A la place du volume de garde, un convertisseur de potentiel 1102 est utilisé. Ce convertisseur 1102 est disposé entre le contrôleur 1002 et le moteur Mo. Ce convertisseur 1102 a pour fonction de :
- recevoir au moins un signal électrique, dit d'entrée, tel qu'un signal d'alimentation ou de commande, émis par le contrôleur 1002 et destiné au moteur Mo, et référencer ledit signal d'entrée au potentiel de garde V_{G} ; et
- recevoir au moins un signal électrique, dit de sortie, émis par ledit moteur Mo et destiné au contrôleur 1002, et référencer ledit signal de sortie au potentiel de masse électrique MG du contrôleur.

Ainsi le moteur Mo, tout comme les connecteurs et l'électronique qui lui sont associés, sont alimentés par des signaux référencés au potentiel de garde V_{G} et ne perturbent pas l'électrode de détection capacitive que constitue la tête fonctionnelle 106.

Bien entendu, un tel convertisseur de potentiel peut aussi être utilisé en combinaison avec le mode de réalisation de la FIGURE 9.

Le convertisseur de potentiel 1102 peut être le convertisseur de potentiel 302 ou 304 des FIGURES 3 ou 4.

La FIGURE 12 est une représentation schématique d'une électronique de détection pouvant être mise en œuvre dans un robot selon l'invention, en particulier dans l'un quelconque des robots des FIGURES 2-5.

Le module électronique 1200, représenté sur la FIGURE 12, peut être le module électronique 120 des FIGURES 2-5.

Le module électronique 1200 comprend un oscillateur 1202 qui génère une tension alternative d'excitation, notée V_{G}, utilisée comme potentiel de garde.

Le module électronique 1200 comprend également une électronique de détection 1204 composée d'un amplificateur de courant, ou de charge, représenté par un amplificateur opérationnel 1206 et une capacité de contre-réaction 1208.

L'électronique de détection 1204 comprend en outre un conditionneur 1210 permettant d'obtenir un signal représentatif de la capacité de couplage Cₑₒ recherchée, et/ou de la présence ou de la proximité d'un objet d'un corps. Ce conditionneur 1210 peut comprendre, par exemple, un démodulateur synchrone pour démoduler le signal par rapport à une porteuse, à une fréquence de travail. Le conditionneur 1210 peut également comprendre un démodulateur asynchrone ou un détecteur d'amplitude. Ce conditionneur 1210 peut, bien entendu, être réalisé sous une forme analogique et/ou numérique (microprocesseur) et comprendre tous moyens nécessaires de filtrage, de conversion, de traitement, etc.

Le module électronique 1200 peut comprendre une électronique de détection 1204 dédiée à chacune des électrodes de détection 118 et à la tête fonctionnelle 110.

Alternativement, et tel que représenté sur la FIGURE 12, le module électronique 1200 peut comprendre une seule électronique de détection 1204 et un moyen de scrutation 1210 reliant ladite électronique de détection 1204, à tour de rôle, à chaque électrode de mesure 118 et à la tête fonctionnelle 110, de sorte à interroger individuellement chacune desdites électrodes de mesure et la tête fonctionnelle 110.

Bien entendu, le module électronique 1200 peut comprendre d'autres composants que ceux décrits.

De plus, le module électronique 1200 peut être au moins en partie intégré dans une électronique du robot, ou dans le corps du robot, ou dans la tête fonctionnelle, ou encore dans une interface existante ou additionnelle, positionnée entre la tête fonctionnelle et le corps du robot.

Le module électronique 1200 peut également se présenter sous la forme d'un module ou d'un boîtier externe au corps du robot. Dans ce cas, tout ou partie des connexions électriques décrites peuvent être localisées au niveau du module électronique 1200 relié aux autres éléments par des câbles.

Bien sûr, l'invention n'est pas limitée aux exemples qui viennent d'être décrits et de nombreux aménagements peuvent être apportés à ces exemples sans sortir du cadre de l'invention tel que défini par les revendications.

## Revendications

1. Robot (200;300;400;500) comprenant une ou plusieurs sous-partie(s) (102-116), dont au moins une (104,114), dite sous-partie appareillée, comportant au moins un organe électrique (104₂,114₂) disposé dans ladite sous-partie (104,114), ledit robot (200;300;400;500) comprenant en outre :
- pour au moins une sous-partie (106,108), dite équipée, au moins une électrode de détection capacitive (118), dite de mesure, disposée sur, ou dans, une paroi externe (106₁,108₁) de ladite sous-partie (106,108),
- au moins un moyen de polarisation électrique (1202) pour polariser ladite au moins une électrode de mesure (118) à un premier potentiel électrique alternatif, différent d'un potentiel de masse générale (MG), à une fréquence, dite de travail, et
- au moins une électronique (1204), dite de détection, pour mesurer un signal relatif à une capacité de couplage, dite capacité électrode-objet, entre l'au moins une électrode de mesure (118) et un objet environnant (OP) ;
**caractérisé en ce que**, pour au moins une sous-partie appareillée (104,114) dont la paroi externe (104₁,114₁) est, au moins en partie, non-conductrice d'électricité, ledit au moins un moyen de polarisation (1202) est en outre agencé pour garder électriquement au moins un organe électrique (104₂,114₂) de ladite sous-partie appareillée (104,114) à un potentiel électrique alternatif (V_{G}), dit de garde, identique ou sensiblement identique audit premier potentiel à ladite fréquence de travail.

2. Robot (200;400) selon la revendication 1, **caractérisé en ce qu'**au moins une sous-partie appareillée (104,114), dont au moins un organe électrique (104₂,114₂) est gardé électriquement au potentiel de garde (V_{G}), comprend un volume (202,206) ou des parois, de garde :
- disposé(es) autour dudit au moins un organe électrique (104₂,114₂), et
- polarisé(es) au potentiel de garde (V_{G}) par l'au moins un moyen de polarisation (1202).

3. Robot selon la revendication 1, **caractérisé en ce qu'**il comprend, dans au moins une sous-partie appareillée, au moins un organe électrique électriquement polarisé, ou référencé, au potentiel de garde (V_{G}) par l'au moins un moyen de polarisation, de sorte à être gardé électriquement au potentiel de garde (V_{G}).

4. Robot (200;300;400;500) selon l'une quelconque des revendications précédentes, **caractérisé en ce qu'**au moins une sous-partie appareillée (104,114), dont au moins un organe (104₂,114₂) est gardé au potentiel de garde (V_{G}), n'est pas une sous-partie équipée.

5. Robot selon l'une quelconque des revendications précédentes, **caractérisé en ce qu'**au moins une sous-partie appareillée, dont au moins un organe est gardé au potentiel de garde, est une sous-partie équipée.

6. Robot (500) selon l'une quelconque des revendications précédentes, **caractérisé en ce qu'**il comprend au moins une sous-partie (104) dont la paroi externe (104₁) est, au moins en partie, électriquement conductrice.

7. Robot (500) selon la revendication précédente, **caractérisé en ce qu'**au moins une partie conductrice de la paroi externe (104₁) d'une sous-partie (104) est polarisée au potentiel de garde (V_{G}) par l'au moins un moyen de polarisation (1202).

8. Robot (200;300;400;500) selon l'une quelconque des revendications 6 ou 7, **caractérisé en ce qu'**au moins une sous-partie (106) dont la paroi externe (106₁) est, au moins en partie, électriquement conductrice, est équipée d'électrodes de mesure (118).

9. Robot (200;300;400;500) selon l'une quelconque des revendications précédentes, **caractérisé en ce qu'**au moins une sous-partie dudit robot est :
- un segment dudit robot (102-108), ou
- une interface mécanique (112-116), articulée ou non, entre au moins deux segments (102-108) dudit robot, ou
- une tête fonctionnelle (110), articulée ou non, formant un outil, ou une tête d'outil.

10. Robot (200;300;400;500) selon l'une quelconque des revendications précédentes, **caractérisé en ce qu'**il comprend une tête fonctionnelle formée par une sous-partie, ladite tête fonctionnelle (110) formant une électrode de détection capacitive, l'au moins un moyen de polarisation étant en outre agencé pour polariser ladite tête fonctionnelle (110) au premier potentiel électrique alternatif, et l'au moins une électronique de détection étant agencée pour mesurer un signal relatif à une capacité de couplage entre ladite tête fonctionnelle (110) et un objet environnant (OP).

11. Robot (200;300;400;500) selon la revendication précédente, **caractérisé en ce qu'**il comprend au moins un organe électrique (Mo) agencé dans la tête fonctionnelle (110), et pour au moins un organe, un volume (1006), ou des parois, de garde, disposé(es) autour dudit au moins un organe (Mo).

12. Robot selon la revendication 11, **caractérisé en ce qu'**il comprend, dans la tête fonctionnelle, au moins un organe électrique électriquement polarisé, ou référencé, au potentiel de garde (V_{G}) par l'au moins un moyen de polarisation, de sorte à être gardé électriquement au potentiel de garde (V_{G}).

13. Robot (200;300;400;500) selon l'une quelconque des revendications 3 ou 12, **caractérisé en ce qu'**il comprend, pour au moins un organe électrique (Mo), au moins un convertisseur électrique (1102) agencé pour :
- recevoir au moins un signal électrique, dit d'entrée, tel qu'un signal d'alimentation ou de commande, destiné audit au moins un organe électrique (Mo), et référencer ledit signal d'entrée au potentiel de garde (V_{G}) ; et/ou
- recevoir au moins un signal électrique, dit de sortie, émis par ledit au moins un organe électrique (Mo), et référencer ledit signal de sortie au potentiel de masse électrique (MG) d'un contrôleur (1002) auquel il est destiné.

14. Robot (200;300;400;500) selon la revendication 13, **caractérisé en ce que** le convertisseur électrique (302,304,1102) comprend :
- au moins une alimentation à isolation galvanique, tel qu'un convertisseur DC/DC, en particulier pour générer un signal d'entrée d'alimentation pour ledit au moins un organe électrique (Mo) ;
- au moins une interface électrique sans contact galvanique, de type capacitive ou par opto-coupleur, pour au moins un signal d'entrée de commande, ou au moins un signal de sortie ;
- une ou plusieurs inductances à impédance élevée pour recevoir et transmettre au moins un signal d'entrée ou au moins un signal de sortie; et/ou
- au moins un convertisseur à transfert de charges, ou à pompe de charge, à base de capacités commutées.

15. Robot (200;300;400;500) selon l'une quelconque des revendications précédentes, **caractérisé en ce que** tous les organes électriques agencés dans ledit robot sont électriquement gardés au potentiel de garde (V_{G}).

16. Robot (200;300;400;500) selon l'une quelconque des revendications précédentes, **caractérisé en ce qu'**il se présente sous l'une des formes suivantes : bras robotisé, robot mobile, véhicule sur roues ou chenilles, robot de type humanoïde, ou gynoïde, ou androïde.

## Patentansprüche

1. Roboter (200; 300; 400; 500) mit einem oder mehreren Unterteil(en) (102-116), darunter wenigstens einer (104, 114), sogenannter ausgerüsteter Unterteil, der wenigstens ein elektrisches Organ (104₂,114₂) umfasst, welches in dem Unterteil (104, 114) angeordnet ist, wobei der Roboter (200; 300; 400; 500) ferner umfasst:
- für wenigstens einen sogenannten ausgestatteten Unterteil (106, 108) wenigstens eine kapazitive Erfassungselektrode (118), sogenannte Messelektrode, die an oder in einer Außenwand (106₁,108₁) des Unterteils (106,108) angeordnet ist,
- wenigstens ein elektrisches Polarisationsmittel (1202) zum Polarisieren der wenigstens einen Messelektrode (118) auf ein erstes elektrisches Wechselpotential, das sich von einem allgemeinen Massepotential (MG) unterscheidet, bei einer sogenannten Arbeitsfrequenz, und
- wenigstens eine sogenannte Erfassungselektronik (1204) zum Messen eines Signals bezüglich einer Kopplungskapazität, sogenannten Elektrode-Objekt-Kapazität, zwischen der wenigstens einen Messelektrode (118) und einem umgebenden Objekt (OP);
**dadurch gekennzeichnet, dass** für wenigstens einen ausgerüsteten Unterteil (104, 114), dessen Außenwand (104₁,114₁) wenigstens teilweise nicht elektrisch leitend ist, das wenigstens eine Polarisationsmittel (1202) ferner dazu eingerichtet ist, wenigstens ein elektrisches Organ (104₂,114₂) des ausgerüsteten Unterteils (104, 114) auf einem elektrischen Wechselpotential (V_{G}), sogenannten Schutzpotential, das bei der Arbeitsfrequenz mit dem ersten Potential identisch oder im Wesentlichen identisch ist, elektrisch zu schützen.

2. Roboter (200; 400) nach Anspruch 1, **dadurch gekennzeichnet, dass** wenigstens ein ausgerüsteter Unterteil (104, 114), von dem wenigstens ein elektrisches Organ (104₂,114₂) auf dem Schutzpotential (V_{G}) elektrisch geschützt ist, ein Schutzvolumen (202, 206) oder -wände umfasst:
- das/die um das wenigstens eine elektrische Organ (104₂,114₂) herum angeordnet ist/sind, und
- durch das wenigstens eine Polarisationsmittel (1202) auf das Schutzpotential (V_{G}) polarisiert ist/sind.

3. Roboter nach Anspruch 1, **dadurch gekennzeichnet, dass** er in wenigstens einem ausgerüsteten Unterteil wenigstens ein elektrisches Organ umfasst, das durch das wenigstens eine Polarisationsmittel auf das Schutzpotential (V_{G}) elektrisch polarisiert oder hierauf bezogen ist, um auf dem Schutzpotential (V_{G}) elektrisch geschützt zu sein.

4. Roboter (200; 300; 400; 500) nach einem der vorhergehenden Ansprüche, **dadurch gekennzeichnet, dass** wenigstens ein ausgerüsteter Unterteil (104, 114), von dem wenigstens ein Organ (104₂,114₂) auf dem Schutzpotential (V_{G}) geschützt ist, kein ausgestatteter Unterteil ist.

5. Roboter nach einem der vorhergehenden Ansprüche, **dadurch gekennzeichnet, dass** wenigstens ein ausgerüsteter Unterteil, von dem wenigstens ein Organ auf dem Schutzpotential geschützt ist, ein ausgestatteter Unterteil ist.

6. Roboter (500) nach einem der vorhergehenden Ansprüche, **dadurch gekennzeichnet, dass** er wenigstens einen Unterteil (104) umfasst, dessen Außenwand (104₁) wenigstens teilweise elektrisch leitend ist.

7. Roboter (500) nach dem vorhergehenden Anspruch, **dadurch gekennzeichnet, dass** wenigstens ein leitender Teil der Außenwand (104₁) eines Unterteils (104) durch das wenigstens eine Polarisationsmittel (1202) auf das Schutzpotential (V_{G}) polarisiert ist.

8. Roboter (200; 300; 400; 500) nach einem der Ansprüche 6 oder 7, **dadurch gekennzeichnet, dass** wenigstens ein Unterteil (106), dessen Außenwand (106₁) wenigstens teilweise elektrisch leitend ist, mit Messelektroden (118) ausgestattet ist.

9. Roboter (200; 300; 400; 500) nach einem der vorhergehenden Ansprüche, **dadurch gekennzeichnet, dass** wenigstens ein Unterteil des Roboters folgendes ist:
- ein Segment des Roboters (102-108) oder
- eine mechanische Schnittstelle (112-116), die gelenkig ist oder nicht, zwischen wenigstens zwei Segmenten (102-108) des Roboters, oder
- ein Funktionskopf (110), gelenkig oder nicht, der ein Werkzeug oder einen Werkzeugkopf bildet.

10. Roboter (200; 300; 400; 500) nach einem der vorhergehenden Ansprüche, **dadurch gekennzeichnet, dass** er einen von einem Unterteil gebildeten Funktionskopf umfasst, wobei der Funktionskopf (110) eine kapazitive Erfassungselektrode bildet, wobei das wenigstens eine Polarisationsmittel ferner dazu eingerichtet ist, den Funktionskopf (110) auf das erste elektrische Wechselpotential zu polarisieren, und wobei die wenigstens eine Erfassungselektronik dazu eingerichtet ist, ein Signal bezüglich einer Kopplungskapazität zwischen dem Funktionskopf (110) und einem umgebenden Objekt (OP) zu messen.

11. Roboter (200; 300; 400; 500) nach dem vorhergehenden Anspruch, **dadurch gekennzeichnet, dass** er wenigstens ein in dem Funktionskopf (110) angeordnetes elektrisches Organ (Mo) und für wenigstens ein Organ ein Schutzvolumen (1006) oder
- wände aufweist, das/die um das wenigstens eine Organ (Mo) herum angeordnet ist/sind.

12. Roboter nach Anspruch 11, **dadurch gekennzeichnet, dass** er in dem Funktionskopf wenigstens ein elektrisches Organ umfasst, das durch das wenigstens eine Polarisationsmittel auf das Schutzpotential (V_{G}) elektrisch polarisiert oder hierauf bezogen ist, um auf dem Schutzpotential (V_{G}) elektrisch geschützt zu sein.

13. Roboter (200; 300; 400; 500) nach einem der Ansprüche 3 oder 12, **dadurch gekennzeichnet, dass** er für wenigstens ein elektrisches Organ (Mo) wenigstens einen elektrischen Wandler (1102) umfasst, der dazu eingerichtet ist:
- wenigstens ein elektrisches Signal, sogenanntes Eingangssignal, wie ein Versorgungs- oder Steuersignal, zu empfangen, das für das wenigstens eine elektrische Organ (Mo) bestimmt ist, und das Eingangssignal auf das Schutzpotential (VG) zu beziehen; und/oder
- wenigstens ein elektrisches Signal, sogenanntes Ausgangssignal, zu empfangen, das durch das wenigstens eine elektrische Organ (Mo) gesendet wird, und das Ausgangssignal auf das elektrische Massepotential (MG) einer Steuervorrichtung (1002), für die es bestimmt ist, zu beziehen.

14. Roboter (200; 300; 400; 500) nach Anspruch 13, **dadurch gekennzeichnet, dass** der elektrische Wandler (302, 304, 1102) umfasst:
- wenigstens eine Versorgung mit galvanischer Isolierung, wie einen DC/DC-Wandler, insbesondere zur Erzeugung eines Versorgungseingangssignals für das wenigstens eine elektrische Organ (Mo);
- wenigstens eine elektrische Schnittstelle ohne galvanischen Kontakt, vom kapazitiven Typ oder durch Optokoppler, für wenigstens ein Steuereingangssignal, oder wenigstens ein Ausgangssignal;
- eine oder mehrere Induktivitäten mit hoher Impedanz zum Empfangen und Weiterleiten wenigstens eines Eingangssignals oder wenigstens eines Ausgangssignals; und/oder
- wenigstens einen Wandler mit Ladungsübertragung, oder Ladungspumpe, auf Basis von geschalteten Kondensatoren.

15. Roboter (200; 300; 400; 500) nach einem der vorhergehenden Ansprüche, **dadurch gekennzeichnet, dass** alle in dem Roboter angeordneten elektrischen Organe auf dem Schutzpotential (V_{G}) elektrisch geschützt sind.

16. Roboter (200; 300; 400; 500) nach einem der vorhergehenden Ansprüche, **dadurch gekennzeichnet, dass** er in einer der folgenden Formen vorliegt: Roboterarm, mobiler Roboter, Rad- oder Raupenfahrzeug, Roboter vom humanoiden Typ, oder Gynoid oder Android.

## Claims

1. A robot (200;300;400;500) comprising one or more sub-part(s) (102-116), at least one of which (104,114), called fitted-out sub-part, comprising at least one electrical item (104₂,114₂) placed in said sub-part (104,114), said robot (200;300;400;500) also comprising:
- for at least one sub-part (106,108), called equipped, at least one capacitive detection electrode (118), called measurement electrode, placed on, or in, an outer wall (106₁,108₁) of said sub-part (106,108),
- at least one means of electrical polarization (1202) for polarizing said at least one measurement electrode (118) at a first alternating electrical potential different from a general ground potential (MG), at a frequency, called working frequency, and
- at least one electronic unit (1204), called detection unit, for measuring a signal relative to a coupling capacitance, called electrode-object capacitance, between the at least one measurement electrode (118) and a nearby object (OP);
**characterized in that**, for at least one fitted-out sub-part (104,114) the outer wall (104₁,114₁) of which is at least partially non-electrically conductive, said at least one polarization means (1202) is also arranged in order to electrically guard at least one electrical item (104₂,114₂) of said fitted-out sub-part (104, 114) at an alternating electrical potential (V_{G}), called guard potential, identical or substantially identical to said first potential, at said working frequency.

2. The robot (200;400) according to claim 1, **characterized in that** at least one fitted-out sub-part (104,114), at least one electrical item (104₂,114₂) of which is electrically guarded at the guard potential (V_{G}) comprises a guard volume (202,206) or walls:
- placed around said at least one electrical item (104₂,114₂), and
- polarized at the guard potential (V_{G}) by the at least one polarization means (1202).

3. The robot according to claim 1, **characterized in that** it comprises, in at least one fitted-out sub-part, at least one electrical item electrically polarized at, or referenced to, the guard potential (V_{G}) by the at least one polarization means, so as to be electrically guarded at the guard potential (V_{G}).

4. The robot (200;300;400;500) according to any one of the preceding claims, **characterized in that** at least one fitted-out sub-part (104,114), at least one item (104₂,114₂) of which is guarded at the guard potential (V_{G}), is not an equipped sub-part.

5. The robot according to any one of the preceding claims, **characterized in that** at least one fitted-out sub-part, at least one item of which is guarded at the guard potential, is an equipped sub-part.

6. The robot (500) according to any one of the preceding claims, **characterized in that** it comprises at least one sub-part (104), the outer wall (104₁) of which is at least partially electrically conductive.

7. The robot (500) according to the preceding claim, **characterized in that** at least one conductive part of the outer wall (104₁) of a sub-part (104) is polarized at the guard potential (V_{G}) by at least one polarization means (1202).

8. The robot (200;300;400;500) according to any one of claims 6 or 7, **characterized in that** it comprises at least one sub-part (106), the outer wall (106₁) of which is at least partially electrically conductive, is equipped with measurement electrodes (118).

9. The robot (200;300;400;500) according to any one of the preceding claims, **characterized in that** at least one sub-part of said robot is:
- a segment of said robot (102-108), or
- a mechanical interface (112-116), articulated or not articulated, between at least two segments (102-108) of said robot, or
- a functional head (110), articulated or not articulated, forming a tool, or a tool head.

10. The robot (200;300;400;500) according to any one of the preceding claims, **characterized in that** it comprises a functional head formed by a sub-part, said functional head (110) forming a capacitive detection electrode, the at least one polarization means also being arranged to polarize said functional head (110) at the first alternating electrical potential, and the at least one electronic detection unit being arranged in order to measure a signal relating to a coupling capacitance between said functional head (110) and a nearby object (OP).

11. The robot (200;300;400;500) according to the preceding claim, **characterized in that** it comprises at least one electrical item (Mo) arranged in the functional head (110), and for at least one item, a guard volume (1006) or walls, placed around said at least one item (Mo).

12. The robot according to claim 11, **characterized in that** it comprises, in the functional head, at least one electrical item electrically polarized at, or referenced to, the guard potential (V_{G}) by the at least one polarization means, so as to be electrically guarded at the guard potential (V_{G}).

13. The robot (200;300;400;500) according to any one of claims 3 or 12, **characterized in that** it comprises, for at least one electrical item (Mo) at least one electrical converter (1102) arranged to:
- receive at least one electrical signal, called input signal, such as a supply or control signal, intended for said at least one electrical element (Mo), and reference said input signal to the guard potential (V_{G}); and/or
- receive at least one electrical signal, called output signal, transmitted by said at least one electrical item (Mo), and reference said output signal to the electrical ground potential (MG) of a controller (1002) for which it is intended.

14. The robot (200;300;400;500) according to claim 13, **characterized in that** the electrical converter (302,304,1102) comprises:
- at least one supply with galvanic isolation, such as a DC/DC converter, in particular for generating a supply input signal for said at least one electrical item (Mo);
- at least one electrical interface without galvanic contact, of the capacitive type or by opto-coupler, for at least one input control signal, or at least one output signal;
- one or more high-impedance inductors for receiving and transmitting at least one input signal or at least one output signal; and/or
- at least one capacitor-commutated charge-transfer or charge-pump converter.

15. The robot (200;300;400;500) according to any one of the preceding claims, **characterized in that** all of the electrical items arranged in said robot are electrically guarded at the guard potential (V_{G}).

16. The robot (200;300;400;500) according to any one of the preceding claims, **characterized in that** it has one of the following forms: robotized arm, mobile robot, vehicle on wheels or tracks, robot of the humanoid, or gynoid or android type.
